# EUROPÄISCHE PATENTSCHRIFT

(11) **EP 0 608 680 B1**
(45) Veröffentlichungstag und Bekanntmachung des Hinweises auf die Patenterteilung: **23.10.1996**
(21) Anmeldenummer: 94100069.7
(22) Anmeldetag: 04.01.1994
(51) Int. Cl.: H03L 1/04, H03L 1/02

(54) **Temperaturstabilisierte Oszillatorschaltung mit extern beeinflussbaren Heizelementen**
Temperature-stabilised oscillator circuit comprising heating elements acted on from the exterior
Circuit comportant un oscillateur stabilisé en température et des éléments de chauffage influençables de l'extérieur

(30) Priorität: 29.01.1993 DE 4302529
(43) Veröffentlichungstag der Anmeldung: 03.08.1994
(73) Patentinhaber: SIEMENS AKTIENGESELLSCHAFT, 80333 München (DE)
(72) Erfinder: Zwack, Eduard, D-82178 Puchheim (DE)

(56) Entgegenhaltungen:
- EP-A- 0 142 826

## Beschreibung

Nachrichtentechnische Einrichtungen, insbesondere Kommunikationseinrichtungen, sind im Sinne des Bildens hochpräziser Wechselsignale, insbesondere Taktsignale, mit temperaturstabilisierten Oszillatorschaltungen ausgestattet. Die Oszillatorschaltungen sind überwiegend durch spannungsgesteuerte Oszillatorschaltungen realisiert, die Teil eines Phasenregelkreises darstellen. Mit Hilfe dieser Phasenregelkreise werden die in den Kommunikationssystemen gebildeten Taktsignale hinsichtlich ihrer Phase synchron zu einem an das Kommunikationssystem herangeführten Referenztaktsignal - z.B. von einer übergeordneten Takteinrichtung übermittelt - gesteuert. Der Phasenregelkreis ist überwiegend durch eine Oszillatorschaltung und einer die Taktsignale weiterverarbeitenden Einrichtung gebildet. In diesen weiterverarbeitenden Einrichtungen, z.B. ein mit entsprechenden Programmen ausgestattetes Mikroprozessorsystem, werden üblicherweise die Steuersignale zur Steuerung der Heizelemente gebildet und an einen separaten Eingang der Oszillatorschaltung zur Steuerung der Heizelemente übermittelt. Die Messung der aktuellen Temperatur in einer Oszillatorschaltung wird hierbei entweder über ein Temperatursensorelement - z.B. ein Halbleiter-Temperatursensor- oder durch einen Temperaturmeßoszillator - bewirkt. Ein Temperaturmeßoszillator ist derart realisiert, daß bei Temperaturänderungen möglichst große Frequenzänderungen der gebildeten Taktsignale hervorgerufen werden. In der weiterverarbeitenden Einrichtung werden diese Temperatursensorsignale oder Meßoszillatorsignale bewertet und die aktuelle Temperatur der Oszillatorschaltung ermittelt. In Abhängigkeit des Temperaturmeßergebnisses wird daraufhin das Heizelement in der Oszillatorschaltung über separate Verbindungen wirksam bzw. unwirksam in der Art gesteuert, daß die Temperatur der Oszillatorschaltung weitgehend konstant bleibt.

Aus der Europäischen Patentschrift EP-A-0 142 826 ist eine Anordnung zur Stabilisierung einer von einem Frequenzgenerator (VCO) abgegebenen Frequenz bekannt. Der beschriebene Temperaturregler weist als Temperatur-Sensor einen temperaturabhängigen Hilfsoszillator (TCO) auf, dessen frequenzbestimmende Elemente in das Thermostatgehäuse integriert sind. Die von diesem Hilfsoszillator abgegebene Frequenz ist nach Maßgabe einer Bezugsfrequenz regelbar und stellt die Stellgröße für die dem Thermostatgehäuse zuzuführende Heizleistung dar.

Die der Erfindung zugrundeliegende Aufgabe ist darin zu sehen, den Aufwand für eine externe Steuerung der in der Oszillatorschaltung angeordneten Heizelemente zu vermindern. Die Aufgabe wird ausgehend von einer Oszillatorschaltung gemäß den Merkmalen des Oberbegriffs des Patentanspruchs 1 bzw. des Patentanspruchs 2 durch dessen kennzeichnende Merkmale gelöst.

Der wesentliche Aspekt der erfindungsgemäßen Oszillatorschaltung besteht darin, daß an die vorhandene Ausgangsverbindung zwischen dem eigentlichen Oszillator und dem Ausgang der Oszillatorschaltung eine Impedanzauswerteeinheit eingefügt und derart ausgestaltet ist, daß eine Veränderung einer am Ausgang angeschlossenen Impedanz bzw. eines Widerstandes erkannt und das Heizelement bzw. die Heizelemente wirksam bzw. unwirksam gesteuert werden. Der wesentliche Vorteil der erfindungsgemäßen Oszillatorschaltung ist darin zu sehen, daß zur Wirksam- bzw. Unwirksamschaltung der Heizelemente auf eine separate Verbindung zwischen einer weiterverarbeitenden Einrichtung und der Oszillatorschaltung verzichtet werden kann und somit der Aufwand hinsichtlich Steckeinrichtungen und Verbindungsleitungen erheblich reduziert wird.

Bei Einsatz eines Meßoszillators in einer Oszillatorschaltung wird die Impedanzauswerteeinheit besonders vorteilhaft an die Ausgangsverbindung zwischen Meßoszillator und dem Meßausgang der Oszillatorschaltung angeschlossen - Anspruch 2. Die Wirksam- bzw. Unwirksamschaltung der Heizelemente wird hierbei durch eine Änderung einer an den Meßausgang der Oszillatorschaltung angeschlossenen Impedanz bzw. eines Widerstandes bewirkt. Bei dieser Realisierungsvariante kann über einen einzigen Meßausgang der Oszillatorschaltung sowohl die Temperatur der Oszillatorschaltung als auch die Wirksam- bzw. Unwirksamschaltung der Heizelemente durchgeführt werden.

Gemäß einer vorteilhaften Ausgestaltung der erfindungsgemäßen Oszillatorschaltung ist das Heizelement bzw. sind die Heizelemente durch Heizwiderstände realisiert, die durch einen seriell geschalteten Steuertransistor in einen Heiz- bzw. Ruhezustand gesteuert werden - Anspruch 3. Dies stellt eine besonders wirtschaftliche Realisierung eines Heizelementes einschließlich einer zugehörigen Steuerung dar.

Die Impedanzauswerteeinrichtung ist vorteilhaft durch einen in die Ausgangsverbindung eingefügten Widerstand sowie durch einen Schalttransistor realisiert, dessen Emitter-Basis-Strecke parallel zum Widerstand und dessen Kollektor emitterfolgegemäß an den Steuereingang des Steuertransistors geschaltet ist, wobei das Schalten des Schalttransistors durch Anschluß unterschiedlicher Impedanzen bzw. Widerstände an den Ausgang bzw. Meßausgang der Oszillatorschaltung bewirkt wird - Anspruch 4. Mit Hilfe dieser sehr aufwandsarmen Realisierung einer Impedanzauswerteeinrichtung ist durch einfaches Variieren einer an den Ausgang bzw. Meßausgang der Oszillatorschaltung angeschlossenen Impedanz - üblicherweise durch Widerstände realisiert - die Wirksam- bzw. Unwirksamsteuerung der Heizelemente möglich.

Die an den Ausgang bzw. Meßausgang anschließbare Impedanz ist besonders wirtschaftlich durch zwei Widerstände realisiert, wobei einer der beiden Widerstände im Sinne einer Änderung der Impedanz durch einen weiteren Schalttransistor wirksam bzw. unwirksam gesteuert wird - Anspruch 5. Der Widerstand, der in die Ausgangsverbindung eingefügt ist, sowie die beiden die Impedanz bildenden Widerstände sind derart zu dimensionieren, daß einerseits durch Wirksam- bzw. Unwirksamsteuerung eines Widerstandes der Schalttransistor geschaltet und zum anderen die Weiterverarbeitung der Taktsignale oder Meßsignale gewährleistet bleibt. Die Weiterverarbeitung findet beispielsweise in einer Verarbeitungseinrichtung eines Phasenregelkreises statt, wobei die in den beiden Widerständen bestehende Impedanz und der weitere Schalttransistor sowie eine hierfür erforderliche Steuerprozedur in der Verarbeitungseinrichtung vorzusehen ist.

Im folgenden wird die erfindungsgemäße Oszillatorschaltung anhand eines Blockschaltbildes näher erläutert.

Die FIG zeigt einen Phasenregelkreis PLL, der aus einer spannungsgesteuerten Oszillatorschaltung VCOS und einer Verarbeitungseinrichtung VE gebildet ist. Die Oszillatorschaltung VCOS weist einen Taktausgang TA auf, an den über Ausgangsverbindungen AV die in einem spannungsgesteuerten Oszillator VCO gebildeten Taktsignale ts - beispielsweise digitale Taktsignale - geführt werden. Der Spannungssteuereingang VE der Oszillatorschaltung VCOS ist mit dem Ausgang A der Verarbeitungseinrichtung VE verbunden.

Des weiteren ist für das Ausführungsbeispiel angenommen, daß in der Oszillatorschaltung VCOS ein Meßoszillator MO angeordnet ist. Dieser Meßoszillator MO ist für die Messung der Temperatur der Oszillatorschaltung VCOS vorgesehen. Hierzu ist der Meßoszillator MO derart ausgestaltet, daß bei Temperaturänderungen möglichst erhebliche Frequenzänderungen der gebildeten, digitalen Meßsignale ms verursacht werden. Dies wird üblicherweise durch die bekannten speziellen Temperaturmeßquarze - nicht dargestellt - erreicht. Die derart gebildeten Meßsignale ms gelangen über eine weitere Ausgangsverbindung AVM zu einem Meßausgang MA der Oszillatorschaltung VCOS. In eine der beiden Leitungen der weiteren Ausgangsverbindungen AVM ist ein Widerstand R1 eingefügt. Parallel zu diesem Widerstand R1 ist die Basis-Emitter-Strecke eines ersten NPN-Schalttransistors T1 geschaltet. Der Kollektor dieses ersten Schalttransistors T1 ist im Sinne einer Emitterfolgeschaltung über einen zweiten Widerstand R2 an die Basis eines zweiten PNP-Steuertransistors T2 geführt, wobei die Basis dieses Steuertransistors T2 über einen dritten Widerstand R3 sowie dessen Emitter mit der Versorgungsspannung VS der Oszillatorschaltung VCOS verbunden ist. Der Kollektor des zweiten Schalttransistors T2 ist mit dem Heizelement HE, das vorzugsweise durch entsprechende Heizwiderstände realisiert ist, verbunden.

Der Meßausgang MA der Oszillatorschaltung VCOS ist über entsprechende Verbindungen auf einen Meßeingang ME der Verarbeitungseinrichtung VE geführt. Die beiden Eingänge des Meßeingangs ME sind sowohl auf eine Prozessoreinrichtung PE - vorzugsweise durch einen Mikroprozessor realisiert - geschaltet sowie über zwei seriell geschaltete, vierte und fünfte Widerstände R4, R5 verbunden. Parallel zum fünften Widerstand R5 ist die Kollektor-Emitter-Strecke eines dritten Transistors T3 geschaltet, wobei dessen Basis auf einen Steuerausgang STA der Prozessoreinrichtung PE geführt ist. An diese Prozessoreinrichtung PE sind des weiteren über einen Taktsignaleingang TE die Taktsignale ts und Referenztaktsignale rts, die beispielsweise von einer übergeordneten Takteinrichtung übermittelt werden, gesteuert. Mit Hilfe einer in der Prozessoreinrichtung PE implementierten PLL-Prozedur PLV werden die phasenregelkreisrelevanten Funktionen, wie beispielsweise Phasenvergleich, Tiefpaßfunktion und D/A-Wandlung der Steuersignale realisiert. Mit Hilfe einer weiteren in der Prozessoreinrichtung PE implementierten Temperatursteuerprozedur TSP werden die am Eingang ET ankommenden Meßsignale ms hinsichtlich ihrer Frequenz bewertet und die aktuelle Oszillatorschaltungstemperatur abgeleitet. Entsprechend dem abgeleiteten Temperaturmeßergebnis wird über den Steuerausgang STA der dritte Steuertransistor T3 derart geschaltet, daß der fünfte Widerstand R5 entweder annähernd kurzgeschlossen ist oder in Serie mit dem vierten Widerstand R4 zwischen die beiden Eingänge des Meßeingangs ME eingeführt wird. Hierdurch wird eine Impedanzänderung, d.h. Widerstandsänderung, am Meßausgang MA der Oszillatorschaltung VCOS bewirkt. Diese Impedanzänderung am Meßausgang MA der Oszillatorschaltung VCOS ruft unterschiedliche Spannungsabfälle am ersten Widerstand R1 hervor. Der erste, vierte und fünfte Widerstand R1, R4, R5 sind derart bemessen, daß die am ersten Widerstand R1 abfallende Spannung entweder ein Durchschalten oder Sperren des ersten Transistors T1 bewirkt. Dieses Durchschalten bzw. Sperren des ersten Transistors T1 steuert den zweiten Steuertransistor T2 entweder in den Sperr- oder Durchschaltezustand. Hierdurch wird das Heizelement HE entweder wirksam oder unwirksam, d.h. stromlos, gesteuert.

Der erste, zweite und dritte Widerstand R1, R2, R3 sowie der erste und zweite Transistor T1, T2 bilden eine Impedanzauswerteeinheit WAE - in der FIG strichpunkiert dargestellt. Bei fehlen eines Meßoszillators MO, z.B. bei einer Realisierung einer Oszillatorschaltung VCOS mit einem Temperatursensor, ist die Impedanzauswerteeinheit WAE in die Ausgangsverbindung AV zwischen dem Oszillator VCO und dem Taktausgang TA einfügbar - durch strichlierte Linien dargestellt. Die durch den vierten und fünften Widerstand R4, R5 und dem dritten Schalttransistor T3 gebildete Steuereinheit ist hierbei an den Takteingang TE der Verarbeitungseinrichtung VE anzuschließen. Bei beiden Varianten sind der vierte und fünfte Widerstand R4, R5 derart zu dimensionieren, daß bei eingefügtem und kurzgeschlossenem fünften Widerstand R5 ein Erkennen und Bewerten der ankommenden Meßsignale ms oder Taktsignale ts möglich ist. Durch das Einfügen einer Impedanzauswerteeinrichtung WAE in der Oszillatorschaltung VCOS und einer Steuereinheit in der Verarbeitungseinrichtung VE kann auf eine separate Verbindung zur Steuerung des Heizelementes HE durch die Verarbeitungseinrichtung VE verzichtet werden, wobei der Aufwandseinsparungen hinsichtlich eventuell einzufügender Stecker und Verbindungsleitungen den geringen schaltungstechnischen Aufwand übersteigen.

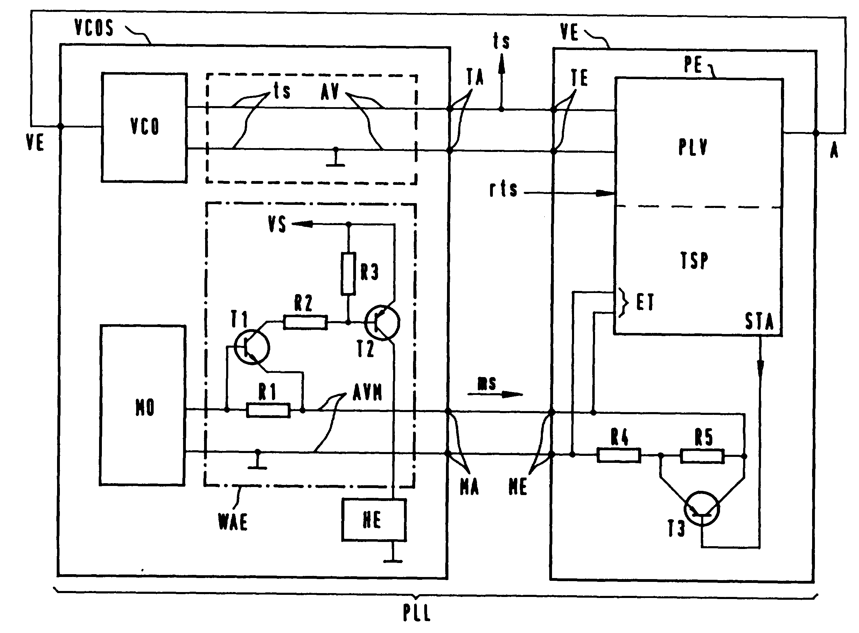

## Patentansprüche

1. Oszillatorschaltung mit zumindest einem die Temperatur konstant haltenden Heizelement, wobei die in einem Oszillator gebildeten Wechselsignale über eine Ausgangsverbindung an einen Ausgang der Oszillatorschaltung geführt werden,
**dadurch gekennzeichnet**,
daß in die Ausgangsverbindung (AV) eine Impedanzauswerteeinheit (WAE) eingefügt und derart ausgestaltet ist, daß eine Veränderung einer am Ausgang (TA) der Oszillatorschaltung (VCOS) angeschlossenen Impedanz (R4, R5) erkannt und das zumindest eine Heizelement (HE) wirksam bzw. unwirksam gesteuert wird.

2. Oszillatorschaltung mit zumindest einem die Temperatur konstant haltenden Heizelement, wobei die in einem Oszillator gebildeten Wechsel signale über eine Ausgangsverbindung an einen Ausgang der Oszillatorschaltung (VCOS) geführt werden und zusätzlich ein zur Messung der Temperatur der Oszillatorschaltung (VCOS) vorgesehener Meßoszillator (MO) angeordnet ist, in dem Meßwechselsignale (ms) gebildet und über eine Meßausgangsverbindung (AVM) an einen Meßausgang (MA) der Oszillatorschaltung (VCOS) geführt werden,
**dadurch gekennzeichnet**,
daß in die Meßausgangsverbindung (AVM) eine Impedanzauswerteeinrichtung (WAE) eingefügt und derart ausgestaltet ist, daß eine Veränderung einer an den Meßausgang (MA) angeschlossenen Impedanz (R4, R5) erkannt und das zumindest eine Heizelement (HE) wirksam bzw. unwirksam gesteuert wird.

3. Oszillatorschaltung nach Anspruch 1 oder 2,
**dadurch gekennzeichnet**,
daß das zumindest eine Heizelement (HE) durch Heizwiderstände realisiert ist, die durch einen seriell geschalteten Steuertransistor (T2) in einen Heiz- bzw. Ruhemodus gesteuert werden.

4. Oszillatorschaltung nach Anspruch 3,
**dadurch gekennzeichnet**,
daß die Impedanzauswerteeinrichtung (WAE)
- durch einen in die Ausgangsverbindung (AV, AVM) eingefügten Widerstand (R1) sowie
- durch einen Schalttransistor (T1) realisiert ist, dessen Emitter-Basis-Strecke parallel zum Widerstand (R1) und dessen Kollektor emitterfolgegemäß an den Steuertransistor (T2) geschaltet ist, wobei das Schalten des Schalttransistors (T1) und des Steuertransistors (T2) durch Anschluß zumindest zweier unterschiedlicher Impedanzen (R4, R5) an den Ausgang (TA) bzw. Meßausgang (MA) der Oszillatorschaltung (VCOS) bewirkt wird.

5. Oszillatorschaltung nach einem der vorhergehenden Ansprüche,
**dadurch gekennzeichnet**,
daß die Impedanz (R4, R5) durch zwei Widerstände (R4, R5) realisiert ist, wobei im Sinne einer Änderung der Impedanz (R4, R5) eine der beiden Widerstände (R4, R5) durch einen weiteren Schalttransistor (T3) wirksam bzw. unwirksam gesteuert wird.

## Claims

1. Oscillator circuit having at least one heating element which keeps the temperature constant, the alternating signals formed in an oscillator (VCO) being fed via an output connection to an output of the oscillator circuit, characterized in that an impedance evaluation unit (WAE) is fitted into the output connection (AV) and is configured in such a way that a change in an impedance (R4, R5) connected to the output (TA) of the oscillator circuit (VCOS) is recognized and the at least one heating element (HE) is activated or deactivated.

2. Oscillator circuit having at least one heating element which keeps the temperature constant, the alternating signals formed in an oscillator (VCO) being fed via an output connection to an output of the oscillator circuit (VCOS), and a measuring oscillator (MO) intended for measuring the temperature of the oscillator circuit (VCOS) is additionally provided, in which measuring alternating signals (ms) are formed and are fed via a measuring output connection (AVM) to a measuring output (MA) of the oscillator circuit (VCOS), characterized in that an impedance evaluation unit (WAE) is fitted into the measuring output connection (AVM) and is configured in such a way that a change in an impedance (R4, R5) connected to the measuring output (MA) is recognized and the at least one heating element (HE) is activated or deactivated.

3. Oscillator circuit according to Claim 1 or 2, characterized in that the at least one heating element (HE) is produced by heating resistors which are switched by a serially connected control transistor (T2) into a heating mode or standby mode.

4. Oscillator circuit according to Claim 3, characterized in that the impedance evaluation device (WAE) is produced
- by a resistor (R1) fitted into the output connection (AV, AVM) and
- by a switching transistor (T1) whose emitter-base path is connected in parallel with the resistor (R1) and whose collector is connected in emitter-follower mode to the control transistor (T2), the switching transistor (T2) and the control transistor (T2) being switched by connecting at least two different impedances (R4, R5) to the output (TA) or measuring output (MA) of the oscillator circuit (VCOS).

5. Oscillator circuit according to one of the preceding claims, characterized in that the impedance (R4, R5) is produced by two resistors (R4, R5), one of the two resistors (R4, R5) being activated or deactivated by a further switching transistor (T3) in order to alter the impedance (R4, R5).

## Revendications

1. Circuit à oscillateur comportant au moins un élément de chauffage maintenant la température constante, dans lequel les signaux alternatifs formés dans un oscillateur (VCO) sont envoyés par l'intermédiaire d'une liaison de sortie à une sortie du circuit à oscillateur,
caractérisé par le fait,
qu'une unité d'évaluation d'impédance (WAE) est insérée dans la liaison de sortie (AV) et est construite de telle sorte qu'une variation d'une impédance (R4, R5) raccordée à la sortie (TA) du circuit à oscillateur (VCOS) est détectée et que le moins un élément de chauffage (HE) soit commandé pour passer à l'état actif ou inactif.

2. Circuit à oscillateur comportant au moins un élément de chauffage maintenant la température constante, dans lequel les signaux alternatifs formés dans un oscillateur (VCO) sont envoyés par l'intermédiaire d'une liaison de sortie à une sortie du circuit à oscillateur (VCOS) et un oscillateur mesureur (MO) prévu pour la mesure de la température du circuit à oscillateur (VCOS) est agencé en plus, des signaux alternatifs de mesure (ms) étant formés dans cet oscillateur mesureur et étant envoyés par l'intermédiaire d'une liaison de sortie de mesure (AVM) à une sortie de mesure (MA) du circuit à oscillateur (VCOS),
caractérisé par le fait,
qu'un dispositif d'évaluation d'impédance (WAE) est inséré dans la liaison de sortie de mesure (AVM) et est construit de telle sorte qu'une variation d'une impédance (R4, R5) raccordée à la sortie de mesure (MA) est détectée et que le au moins un élément de chauffage (HE) soit commandé pour passer à l'état actif ou inactif.

3. Circuit à oscillateur selon la revendication 1 ou 2,
caractérisé par le fait que,
le au moins un élément de chauffage (HE) est constitué de résistances de chauffage qui sont commandées en mode de chauffage ou en mode de repos par un transistor de commande (T2) branché en série.

4. Circuit à oscillateur selon la revendication 3,
caractérisé par le fait que,
l'unité d'évaluation d'impédance (WAE) est mise en oeuvre
- au moyen d'une résistance (R1) insérée dans la liaison de sortie (AV, AVM) et
- au moyen d'un transistor de commutation (T1), dont la voie émetteur-base est branchée en parallèle avec la résistance (R1) et dont le collecteur est branché en un montage émetteur suiveur au transistor de commande (T2), la commutation du transistor de commutation (T1) et du transistor de commande (T2) étant provoquée par le raccordement d'au moins deux impédances différentes (R4, R5) à la sortie (TA) ou à la sortie de mesure (MA) du circuit à oscillateur (VCOS).

5. Circuit à oscillateur selon l'une des revendications précédentes,
caractérisé par le fait que,
l'impédance (R4, R5) est mise en oeuvre au moyen de deux résistances (R4, R5), une des deux résistances (R4, R5) étant commandée pour passer à l'état actif ou inactif par un autre transistor de commutation (T3) afin de faire varier l'impédance (R4, R5).
